Europäisches Patentamt

European Patent Office

Office européen des brevets

(19)

(11) Publication number: **0 450 951 A2**

(12) # EUROPEAN PATENT APPLICATION

(21) Application number: 91302959.1

(51) Int. Cl.$^5$: **H03M 3/02**

(22) Date of filing: 04.04.91

(30) Priority: 23.04.90 US 513452
06.04.90 US 505384
10.07.90 US 550763
24.01.91 US 645157

(43) Date of publication of application:
09.10.91 Bulletin 91/41

(84) Designated Contracting States:
DE FR GB IT NL

(71) Applicant: GENERAL ELECTRIC COMPANY
1 River Road
Schenectady, NY 12345 (US)

(72) Inventor: Ribner, David Byrd
3 Chestnut Lane
Schenectady, New York 12309 (US)

(74) Representative: Pratt, Richard Wilson et al
London Patent Operation G.E. TECHNICAL
SERVICES CO. INC. Burdett House 15/16
Buckingham Street
London WC2N 6DU (GB)

(54) **Analog-to-digital converter.**

(57) An improved modulator network for an interpolative oversampled (sigma-delta) analog-to-digital converter comprises a second-order modulator (20), which performs double integration (22,24) of error between its digital output signal and its analog input signal, and a first-order modulator (30), which performs single integration (36) of error between its digital output signal and an analog signal supplied thereto from the second-order modulator. The modulators(20,30) supply their output signals to a digital error cancellation circuit (44,46,48) which suppresses in the signal supplied to a decimation filter (50) the quantization noise arising in the second-order modulator (20). The network exhibits significantly reduced sensitivity to the practical nonidealities that normally limit the resolution of analog-to-digital converters of this type, i.e., component matching, amplifier nonlinearity, finite gain, settling time, and signal dynamic range.

EP 0 450 951 A2

FIG. 3

The present invention relates to an analog-to-digital converter. An illustrative embodiment of this invention relates to a third-order sigma-delta analog-to-digital converter and, more particularly, to a third-order sigma-delta oversampled analog-to-digital converter network with low sensitivity component mismatch and finite amplifier gain.

High resolution analog-to-digital (or A/D) signal conversion can be achieved with lower resolution components through the use of oversampled interpolative (or sigma-delta modulation followed by digital low pass filtering and decimation. Oversampling refers to operation of the modulator at a rate many times above the signal Nyquist rate, whereas decimation refers to reduction of the clock rate down to the Nyquist rate.

Sigma delta modulators (sometimes referred to as delta sigma modulators) have been used in analog-to-digital converters for some time. Detailed general information can be obtained from the following technical articles which are hereby incorporated by reference.

1) "A Use of Limit Cycle Oscillators to Obtain Robust Analog to Digital Converters", J.C. Candy, IEEE Transactions on Communications, Vol. COM-22, No. 3, pp. 298-305, March 1974

2) "Using Triangularly Weighted Interpolation to Get 13-Bit PCM from a Sigma-Delta Modulator", J.C. Candy, et al., IEEE Transactions on Communications, Vol. COM-24, No. 11, pp. 1268-1275, November 1976

3) "A Use of Double Integration in Sigma Delta Modulation", J.C. Candy, IEEE Transactions on Communications, Vol. COM-33, No. 3, pp. 249-258, March 1985.

Substantial effort has been expended in the field of oversampled analog-to-digital converter design to develop plural-order sigma-delta modulators in order to obtain higher resolution for a given oversampling ratio. As the term "order" is used herein, the order of a sigma-delta modulator is determined directly by how many times the error between its output and input signals is integrated with respect to time, while the order of a sigma-delta converter stage within a plural-stage sigma-delta A/D converter is determined directly by how many times the input signal to that stage is integrated with respect to time in reaching the output connection of that stage.

In the above type of analog-to-digital converter, resolution is predominantly governed by two factors: (1) the ratio of the modulator clock to the Nyquist rate, henceforth referred to as the oversampling ratio, and (2) the "order" of the modulator. "Order" in this context is analogous to the order of a frequency selective filter and indicates the relative degree of spectral shaping that is provided by the modulator. As with a filter, higher selectivity is obtainable with a higher order at the expense of increased hardware complexity. In recognition of these two factors, recent implementations of high resolution oversampled analog-to-digital converters have employed both large oversampling ratios and high modulator order. However, practical considerations can limit the extent to which oversampling rate and modulator order can be taken. For instance, for a given modulator clock rate, the oversampling ratio is inversely proportional to the Nyquist rate after decimation and thus cannot be made arbitrarily high without sacrificing conversion rate. Different considerations set bounds on the modulator order. Implementations of order greater than two, using a single quantizer, can be shown to be only conditionally stable and are therefore not viable.

An alternative approach can be used to effectively provide high order noise shaping with cascaded low-order modulators to ensure stable operation. Unfortunately, the matching of the modulators in such structure is crucial, and the degree of mismatch governs accuracy of the overall converter. Requirements of close component matching and high operational amplifier (or "op amp") gains imply that such circuit can only be manufactured with a low yield, and possibly will require trimming, thereby being expensive to produce.

Early work in this field has been directed at implementation of modulators of first and second order, due to the stability concerns associated with orders of three or greater. T. Hayashi et al., in "A Multistage Delta-Sigma Modulator Without Double Integrator Loop", Proc. IEEE 1986 Int. Solid-State Circuits Conf., pp. 182-183, Feb. 1986, describe an approach in which second-order performance is obtained using a cascade connection of two first-order stages. The quantization error of the first stage is supplied to the second stage so that the second stage output signal, after a digital differentiation, contains a replica of the frequency-shaped quantization noise. Finally, a subtraction of the second stage output signal from that of the first stage yields a signal that contains only the quantization noise of the second stage with second-order noise-shaping. However, this method requires tight matching of the characteristics of the two first-order modulators and high op amp gains. Furthermore, there is a strong desire to employ a third-order modulator in which first- and second-order quantization noise do not accompany the digital output signal generated by the oversampling analog-to-digital converter network.

An extension of the Hayashi et al approach to third-order analog-to-digital converter networks using a triple cascade connection of first-order modulators is described by Y. Matsuya et al. in "A 16-Bit Oversampling A-D Conversion Technology Using Triple Integration Noise Shaping", IEEE J. Solid-State Circuits, Vol. SC-22, No. 6, pp. 921-929, Dec. 1987. However, this approach requires even tighter component matching and also requires high op amp gains in order to achieve the theoretically obtainable resolution.

A slightly different approach is disclosed by L. Longo and M.A. Copeland in "A 13-Bit ISDN-Band ADC Using Two-Stage Third Order Noise Shaping", Proc. 1988 Custom Integrated Circuit Conf., pp. 21.2.1-4, June 1988, wherein a second-order modulator is connected in cascade with a first-order modulator to implement third-order noise-shaping. This approach has the advantage of reducing the component matching requirements somewhat from the other implementations.

An improved third-order sigma-delta analog-to-digital converter which achieves third-order noise-shaping with reduced sensitivity to component mismatching, finite amplifier gain and other nonideal circuit attributes, herein referred to as "nonidealities" was sought by the present inventor. Improved architectures for third-order sigma-delta analog-to-digital converters which can be implemented as sampled data switched- capacitor circuits were sought by the present inventor. The present inventor also sought to provide third-order quantization noise-shaping in a third-order sigma-delta analog-to-digital converter with a modulator network architecture that employs amplifiers of finite gain and is relatively insensitive to normal circuit nonidealities so that A/D converter resolution approaching the theoretical limits can be obtained.

A new third-order sigma-delta analog-to-digital converter network has been developed by the present inventor that exhibits significantly reduced sensitivity to the practical nonidealities that normally limit resolution of prior-art third-order sigma-delta analog-to-digital converter networks, i.e., component mismatching, amplifier non-linearity, finite gain, excessive settling time, and limited signal dynamic range. Thorough simulations, taking into account nonidealities, indicate that 16-bit resolution at an 80 kHz conversion rate is achievable with the new A/D converter network operated at an oversampling ratio of 64. This performance is attainable despite component matching of only 2% and op amp gains as low as 1000. The realization of these performance levels despite only modest required circuit specifications indicate that a low cost, highly manufacturable A/D converter network is now practicable. MOS, CMOS, BiCMOS, GaAs. or Bipolar integrated circuit technologies can be used with this new A/D converter network to implement a completely monolithic A/D converter network with no external components other than decoupling capacitors. The modest complexity of the new A/D converter network provides for efficient implementation of digital signal processing chips with high resolution multi-channel analog interfaces.

CT scanners use a fan beam energy source, a central ray of which is projected through a particular point in space near the center of the object being scanned, as the energy source is stepped around a circular locus with center at that particular point in space. An arcuate strip of detector elements is located opposite the energy source on the other side of that particular point in space from the energy source and tracs the rotation of the energy source about that particular point in space. The object being scanned is always within the fan beam and absorbs a portion of the radiant energy in each contiguous segment of the fan beam, with the remnant radiant energy or "ray sum" in each segment of the fan beam being measured by a respective detector on the arcuate detector strip. The detector responses for each successive increment of rotation of the energy source and its opposing arcuate detector strip constitutes a -separate "view" of the object being scanned. These detector responses during the successive views are stored in memory, since processing of these responses is not done in real time but rather is done after the scan is completed. During this subsequent processing the detector responses from each view are preweighted and prefiltered with a carefully formulated finite-impulse filter kernel before being back projected into the image space to generate the gray scale values of the image picture elements or "pixels". The ray sums passing through each pixel center during each view are weighted and summed to create the gray scale value of the pixel by back projection. That is, since each ray sum represents the sum of the energy absorbed from a bundle of rays forming a segment of the fan beam in its traverse through successive portions of the object including the portion at which the pixel is located, the magnitude of the energy absorption ascribable to any one of the pixels traversed by that segment of the fan beam can be ascertained by performing an autocorrelation procedure involving all of the ray sums for bundles of rays passing through that pixel. This autocorrelation procedure suppresses the shadows cast by the pixels before and after the pixel of interest in the ray sums, which is the essence of producing a tomogram by computed tomography. In the additive combining of ray sums involved in implementing this autocorrelation procedure, each ray sum must be weighted to take into account the divergence of the fan beam before the ray packet associated with that pixel passes through that pixel.

Although the Fourier inversion approach to computed tomography has inherent speed advantage over back-projection reconstruction, it is considered to be unsuitable for use with the fan beam scanner because of excessive sensitivity to noise. The convolution and back-projection reconstruction method is suitable for view pipelining and yields images that are relatively free of undesirable artifacts from processing. A paper "Convolution Reconstruction Techniques for Divergent Beams" by G.T. Herman, A.V. Lakshminarrayan and A. Naparstek appearing on pages 259-271 of COMPUTER BIOLOGIC MEDICINE, Vol. 6, Oct. 1976, is of interest. So is a paper "Rapid Execution of fan Beam Image Reconstruction Algorithms Using Efficient Computational Techniques and Special Purpose Processors" by B.K. Gilbert, S.K. Kenue, R.A. Robb, A. Chu, A.H. Lent and E.E. Swartzlander, Jr. appearing on pages 98-115 of the IEEE TRANSACTIONS ON BIOMEDICAL ENGINEERING, Vol. BME-28, No. 2, feb. 1981.

The strip of detector elements includes a linear array of several hundred or so scintillators and a linear array of several hundred or so photodiodes arrayed behind the linear array of scintillators. The scintillators convert the x-ray image into a light image, and the photodiodes convert the photons in elements of this light image to electric charge. The photodiodes are provided with respective pre-amplifiers, usually transresistance amplifiers providing a low input impedance for sensing photodiode current and providing a low output impedance for driving subsequent circuitry. In prior-art CT systems the photodiode-preamplifier combinations are apportioned amongst subgroups of the entire group of such combinations, and the analog output voltages from the preamplifiers in each subgroup are time-division multiplexed to the input port of a shared analog-to-digital (or A/D) converter.

In practice it has proven to be difficult to match the conversion characteristics of the A/D converters for the various subgroups owing to the need for a very high number of bits (i.e., 16-20 bits) of resolution in converter output signals in order to perform the back-projection calculations. The linearity of the conversion characteristics of the A/D converters is made as good as possible, but differences in the conversion characteristics cause "banding artifacts" in the final tomogram if the photodiodes in each subgroup of photodiode-preamplifier combinations are adjacent to each other in the strip of detector elements. These banding artifacts appear as intensity variations with considerable lower spatial frequency, so they are objectionably noticable to a human viewer of the final tomogram. To reduce the visibility of artifacts attributable to differences in the A/D converter conversion characteristics, the practice has been to scramble the locations in the strip of detector elements of the photodiodes in each subgroup of photodiode-preamplifier combinations, so there is lessened likelihood of low-spatial-frequency components of these artifacts in the tomogram, but increased likelihood of higher-spatial-frequency components of these artifacts in the tomogram. The higher-spatial-frequency components of these artifacts may also be low-pass spatially filtered against, if desired, with loss only of some high-spatial-frequency detail in the tomogram. The practice of scrambling the connections of photodiode-preamplifier combinations to the time-division-multiplexed A/D converters leads to undesirably complex electrical interconnections amongst the elements of the CT system, however, complicating data transfer using time-division multiplexing via a high-speed digital bus.

The practice of scrambling the connections of photodiode-preamplifier combinations to the time-division-multiplexed A/D converters interferes with the desire to locate the preamplifier and A/D converter as close to the photodiode as physically possible, in order to help minimize the pick-up of extraneous electrical signals as noise. The A/D converter and the pre-amplifiers time-division multiplexed to it are normally constructed in monolithic integrated circuit (IC) form, and extensive cabling is needed to connect the photodiodes to this IC where the photodiode scrambling practice is followed. Since the output impedance level of a photodiode is of the order of 30 megohms, the pick-up of extraneous electrical signals on the cabling is likely to be appreciable.

An alternative method of lessening the likelihood of low-spatial-frequency components of the artifacts of differences of A/D converter conversion characteristics, the inventor points out, is to provide each of the photodiode-preamplifier combinations with its own A/D converter. Indeed, this practice further eliminates the self-correlation of A/D converter conversion characteristics that underlies the generation of banding artifacts. This practice also avoids multiplexing in the analog regime and the dynamic range limitations that arise in such analog multiplexing. Providing each of the photodiode-preamplifier combinations with its own A/D converter leaves the formidable problem of finding an A/D converter with sufficient linearity and number of bits of usable resolution to provide tomograms with acceptably low artifacts attributable to differences in the A/D converter conversion characteristics, which A/D converters are of simple and cheap enough construction to be used by the hundreds.

The simplicity of sigma-delta A/D converters was one factor that led the inventor to considering using one after each photodiode-preamplifier combination in a CT scanner, in an effort to avoid the generation of banding artifacts. Sigma-delta A/D converters having single-bit digital-to-analog converters in the feedback loops of their sigma-delta modulators can have very linear conversion characteristics also. The inventor also discerned the possibility that the decimation filter of the sigma-delta A/D converter could perform a dual function, by providing the carefully formulated finite-impulse filtering needed to suppress high-frequency pre-amplifier noise before the detector responses were back projected into the image space to generate the gray scale values of the image picture elements or "pixels". A sampled-data FIR filter using tapped digital delay lines clocked at the oversampling rate, or a functionally equivalent structure, would automatically adjust its bandwidth to accommodate different oversampling rates.

A problem that is encountered when one wishes to time-division-multiplex the digital outputs from a plurality of sigma-delta A/D converters digitizing photodiode responses is the necessity of processing a sufficiency of input signal samples at the oversampling rate so that the finite-impulse-response (FIR) decimation filters have a sufficiency of input samples to span the filter kernel -- i.e., enough input samples to be weighted with all the FIR filter tap weights --within the time allotted to each photodiode to sense its portion of the light image. This becomes a more difficult problem when the decimation filter of the sigma-delta A/D converter also provides the carefully formulated finite-impulse filtering needed to suppress high-frequency preamplifier noise before the detector responses At the CT scanner rates and the bits of detector resolution demanded in order to be commercially competitive, the inventor has determined, the oversampling ratio tends to become excessive when attempting to use a single first-order sigma-delta modulator in each A/D converter. The third-order sigma-delta oversampled converters herein disclosed are particularly well-suited to using one after each photodiode-preamplifier combination in a CT scanner, so as to avoid the generation of banding artifacts.

An oversampled interpolative (sigma-delta) analog-to-digital converter network embodying the invention includes a second-order modulator receiving the analog signal to be converted as its input signal and responding with a digital output signal thereof from an analog-to-digital converter therewithin, which analog-to-digital converter introduces a quantizing error that appears in doubly differentated form as an undesired quantization noise component of the digital output signal of the second-order modulator; a first-order modulator, receiving the digital output signal of the second-order modulator minus the quantizing error introduced by the analog-to-digital converter within the second-order modulator, and responding with a digital output signal thereof from an analog-to-digital converter therewithin; and a digital error- cancellation circuit for combining the digital output signals of the second-order modulator and the first-order modulator to obtain a digital output signal descriptive of the analog signal received as input signal by the second-order modulator, but substantially free of the undesired quantization noise component from the second-order modulator.

The invention will be better understood from the following illustrative description of a preferred embodiment of the invention with reference to the drawings, in which:

Figure 1 is a circuit block diagram illustrating a known sigma-delta analog-to-digital converter;

Figures 2(a), 2(b), 2(d) and 2(e) illustrate typical power spectra associated with operation of the analog-to-digital converter of Figure 1, while Figure 2(c) represents a typical filter characteristic for the decimation filter of Figure 1;

Figure 3 is a circuit block diagram illustrating a third-order sigma-delta analog-to-digital converter network in accordance with the present invention;

Figure 4 is a functional block diagram of one version of the Figure 3 type of third-order sigma-delta analog-to-digital converter network embodying the present invention;

Figure 5 is a functional block diagram of a specific embodiment of the Figure 3 type of third-order sigma-delta analog-to-digital converter network of the present invention;

Figure 6 is a circuit block diagram of a sampled data single-ended switched capacitor implementation of the third-order sigma-delta analog-to-digital converter network of Figure 5;

Figure 7 is a circuit block diagram of a sampled data differential switched capacitor implementation of the third-order sigma-delta analog-to-digital converter network of Figure 5;

Figure 8 illustrates waveforms of clock signals employed in the circuit of Figure 7;

Figure 9 is a circuit block diagram of a decimation filter that can be used in the third-order sigma-delta analog-to-digital converter networks of Figures 3, 4 and 5.

Figure 10 is a circuit block diagram illustrating a third-order sigma-delta analog-to-digital converter network in accordance with the present invention, which is of a type alternative to the figure 3 type;

Figure 11 is a functional block diagram of one version of the figure 10 type of third-order sigma-delta analog-to-digital converter network embodying the present invention;

Figure 13 is a circuit block diagram illustrating a third-order sigma-delta analog-to-digital converter network in accordance with the present invention, which is of a type alternative to the Figure 3 and Figure 9 types; and

Figure 14 is a functional block diagram of one version of the Figure 13 type of third-order sigma-delta analog-to-digital converter network embodying the present invention.

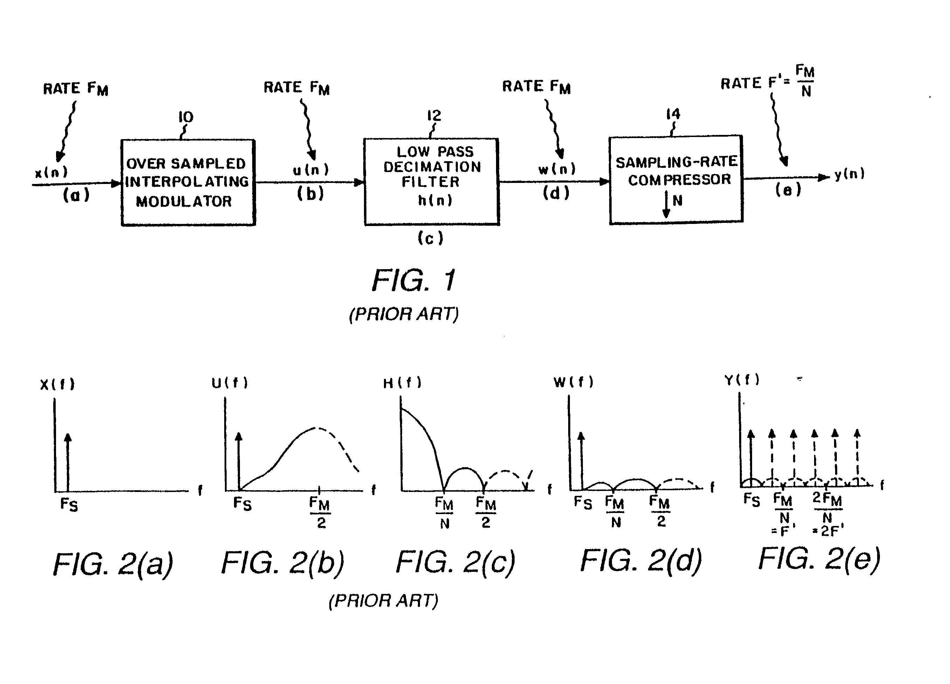

Figure 1 shows a known embodiment of sigma-delta analog-to-digital converter in which an oversampled interpolative (sigma-delta) modulator 10 is coupled to a low pass decimation filter 12 which, in turn, is coupled to a sampling-rate compressor 14. The role of modulator 10 is to shape spectrally the quantization noise of a low resolution analog-to-digital converter so that it is predominantly concentrated at high frequency. The input signal x(n) to modulator 10 is a pure sinusoid of frequency FS and is sampled by modulator 10 at a sampling rate FM. Subsequent low pass filtering and decimation can be used to remove the bulk of the quantization noise, resulting in a high resolution digital output signal at a reduced conversion rate FM/N where N is the oversampling ratio, or ratio of the output clock rate (F') to the input clock (or sample) rate FM.

In Figure 1, the following functions are represented: input signal x(n), modulator output signal u(n), filter

6

output signal w(n), and A/D converter output signal y(n) along with the filter impulse response characteristic h(n). The corresponding frequency spectra $|X(f)|$, $|U(f)|$, $|W(f)|$, and $|Y(f)|$, and filter characteristic $|H(f)|$, respectively, are shown in figures 2(a), 2(b), 2(d), 2(e) and 2(c), respectively, and represent the conditions in the circuit of Figure 1 at locations (a), (b), (d), (e) and (c), respectively. These frequency spectra illustrate the noise shaping provided by modulator 10 and the high frequency noise rejection provided by low pass decimation filter 12 prior to the sampling rate conversion performed by compressor 14.

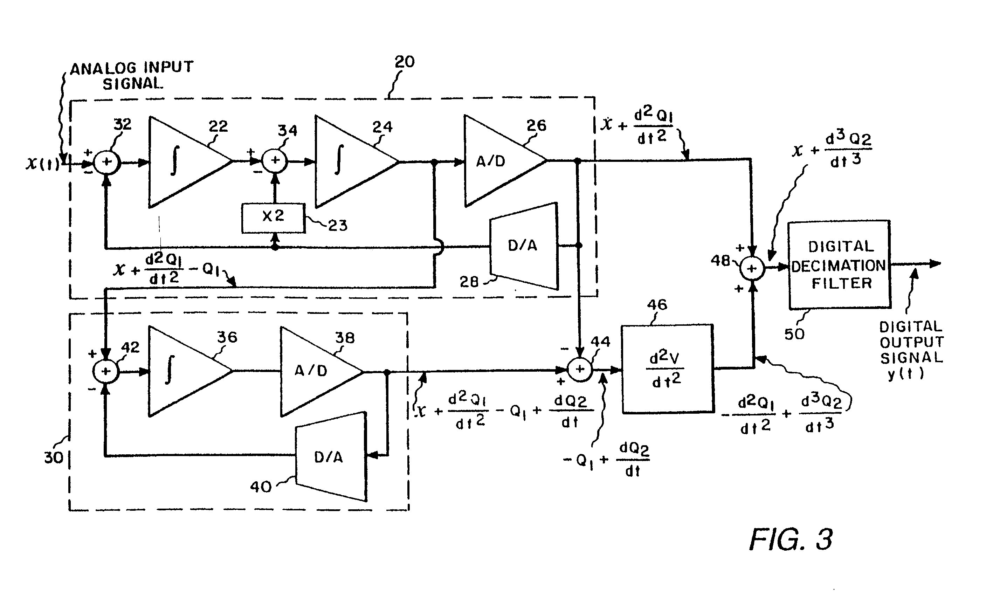

A simplified block diagram of a third-order sigma-delta analog-to-digital converter network embodying the invention is shown in figure 3 and includes a second-order modulator 20 coupled to a first-order modulator 30. Second-order modulator 20 includes a pair of cascaded integrators 22 and 24, an analog-to-digital converter 26 coupled to the output of integrator 24, and a digital-to-analog (D/A) converter 28 coupled in a first feedback loop between the output of analog-to-digital converter 26 and the input of integrator 22 via a subtractive summing unit 32 and in a second feedback loop between the output of analog-to-digital converter 26 and the input of integrator 24 via an amplifier 23 having a gain of 2 and a subtractive summing unit 34 connected in series.

Second-order modulator 20 responds to an analog input signal x(t) and at low frequencies $\omega \ll \pi/T$, where T is the sampling period and $T = 1/F_m$, produces a digital output signal of approximately

$$x + d^2Q_1/dt^2$$

containing a component x, which is a digital representation of the ideal analog input signal, along with a shaped quantization noise signal $d^2Q_1/dt^2$. The quantizing noise $Q_1$ generated during analog-to-digital conversion by the analog-to-digital converter 26 within the second-order modulator 20 is doubly differentiated by the two-integrator loop and pushed to substantially higher frequency in the output signal from the second-order modulator 20. The signal applied to analog-to-digital converter 26 is an analog signal

$$x + d^2Q_1/dt^2 - Q_1$$

equal to the digital output signal $x + d^2Q_1/dt^2$ less the additive quantization noise $Q_1$ and is applied to first-order modulator 30.

First-order modulator 30 includes a single integrator 36 coupled to an analog-to-digital converter 38. A digital-to-analog converter 40 is coupled in a feedback loop between the output of analog-to-digital converter 38 and the input of integrator 36 via a subtractive summing unit 42. The quantizing noise $Q_2$ generated during analog-to-digital conversion by the analog-to-digital converter 38 within the first-order modulator 30 is differentiated by the single-integrator loop and pushed to higher frequency in the output signal from the first-order modulator 30. First-order modulator 30, at low frequencies $\omega \ll \pi/T$, produces a digital output signal of approximately

$$x + d^2Q_1/dt^2 - Q_1 + dQ_2/dt$$

which is equal to an exact replica of its input signal plus the differentiated additive quantization noise signal $dQ_2/dt$.

A digital subtractor 44 is coupled to the outputs of second-order modulator 20 and first-order modulator 30 to determine the difference between the digital output signals from modulators 20 and 30. A digital double differentiator 46 is coupled to the output of digital subtractor 44 for twice differentiating the digital difference signal from digital subtractor 44. A digital adder 48 is coupled to the outputs of second-order modulator 20 and digital double differentiator 46 to add the digital output signal from modulator 20 to the resultant digital output signal produced by digital double differentiator 46. The digital output signal produced by adder 48 is applied to a digital decimation filter 50.

Ignoring for now the output quantization noise $dQ_2/dt$ of modulator 30, the difference between the two digital output signals from modulators 20 and 30 is exactly equal to minus the quantization noise $(-Q_1)$ of second-order modulator 20. A double differentiated signal $(-d^2Q_1/dt^2)$ from digital double differentiator 46 is added to the digital output signal of second-order modulator 20 by digital adder 48 to effect the cancellation of the quantization noise $Q_1$ of modulator 20.

Considering now the quantization noise signal $dQ_2/dt$ that was previously ignored, the noise signal $Q_2$ has been differentiated once by first-order modulator 30, generating a signal $dQ_2/dt$. It is further differentiated two more times by digital differentiator 46 so that, in the output signal y(t) from adder 48, the only noise is the triple differentiated noise signal $d^3Q_2/dt^3$. This amounts to a third-order shaping of the quantization noise which greatly attenuates its baseband components and emphasizes its high frequency power. The triple differentiated noise signal $d^3Q_2/dt^3$ is effectively eliminated from the final digital output signal by digital decimation filter 50.

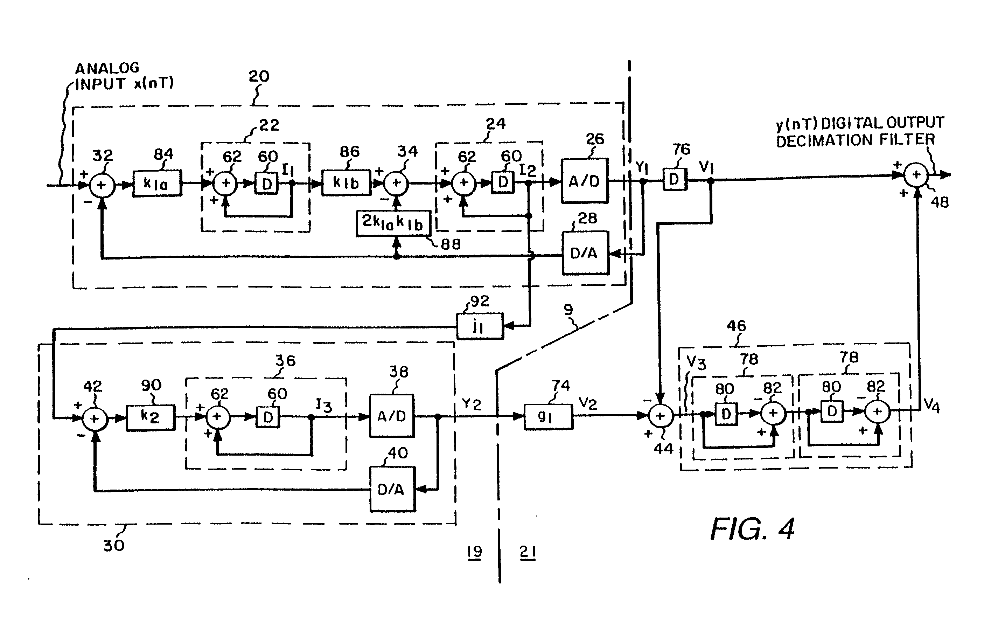

The intended implementation of the third-order sigma-delta analog-to-digital converter network is in a sampled data switched capacitor circuit in accordance with the discrete-time domain functional block diagram of Figure 4. A design objective with oversampled modulators is the scaling of analog signal levels to be on the order of the reference voltage. Therefore, a discrete time version is shown in Figure 4 to indicate that such version is possible for the new converter network of the present invention.

In Figure 4, each of integrators 22, 24 and 36 is shown as a one-cycle delay register 60 preceded by an adder (or summing) unit 62. Digital double differentiator 46 is shown as a pair of cascaded differentiators 78, each comprising a delay register 80 followed by a digital subtractor 82.

An amplifier 84 having a gain coefficient $k_{1a}$ is situated in second-order modulator 20 at the input to an integrator 22 and following a summing unit 32. An amplifier 86 with a gain coefficient $k_{1b}$ couples the output of integrator 22 to the input of an integrator 24 through a summing unit 34. Another amplifier 88 with a gain coefficient $2k_{1a}-k_{1b}$ is situated in a feedback loop of second-order modulator 20 between the output of a digital-to-analog converter 28, and a negative input to summing unit 34, while a second feedback loop in modulator 20 is provided by coupling the output of converter 28 to a negative input of summing unit 32. An amplifier 92 of gain $j_1$ couples the output of integrator 24 to a subtractive summing unit 42 in first-order modulator 30, while an amplifier 90 having gain coefficient $k_2$ is situated at the input of integrator 36 after summing unit 42 in modulator 30.

A digital multiplier 74 having a multiplier coefficient $g_1$ couples the output of analog-to-digital converter 38 of first-order modulator 30 to digital subtractor 44, while digital-to-analog converter 40 couples the output of analog-to-digital converter 38 to subtractive summing unit 42. The output of analog-to-digital converter 26 of second-order modulator 20 is connected through a delay register 76 to the negative input of digital subtracter 44 and to digital adder 48. A dashed line 9 designates the separation between digital circuitry 21 and analog circuitry 19.

In Figure 4, coefficients $k_{1a}$, $k_{1b}$, $k_2$, and $j_1$ are analog scaling coefficients, whereas g1 is a digital multiplier coefficient. These coefficients must be related according to:

$$j_1g_1 \;=\; 1/(k_{1a}k_{1b}). \quad (1)$$

These relationships have meaning only for the case where only one-bit analog-to-digital converters and only one-bit digital-to-analog converters are used. Normally the k coefficients are selected to be less than one so as to reduce the level of internal voltages within the modulator and thereby avoid clipping. Analysis of the network of figure 4 results in an input signal/output signal relationship in the discrete time domain of

$$v_o(n) \;=\; v_i(n-3) \;+\; g_1[e_2(n) - 3e_2(n-1) \;+\; 3e_2(n-2) - e_2(n-3)] \quad (2)$$

and of

$$V_o(z) \;=\; z^{-3}V_i(z) \;+\; g_1(1-z^{-1})^3 E_2(z) \quad (3)$$

in the corresponding frequency domain, where n represents the discrete time instant nT (T being the sample period), z is the discrete time frequency variable and $E_2$ is the quantization error of the second stage. It should be noted that a trade-off exists between voltage levels and output noise intensity; specifically, if scaling is employed, then the condition $k_{1a}k_{1b}<1$ imposes $g_1>1$, and the output error is increased proportionately as indicated by Equations 2 and 3.

While the implementation shown in figure 4 implies the use of one-bit A/D converters and D/A converters, improvements in performance can be achieved by using multiple bit A/D and D/A converters. For cases where the quantization levels L are greater than one bit, i.e., L>1, then $k_{1a} = k_{1b} = k_2 = 1$ in Figure 4 and $j_1g_1 = 1$.

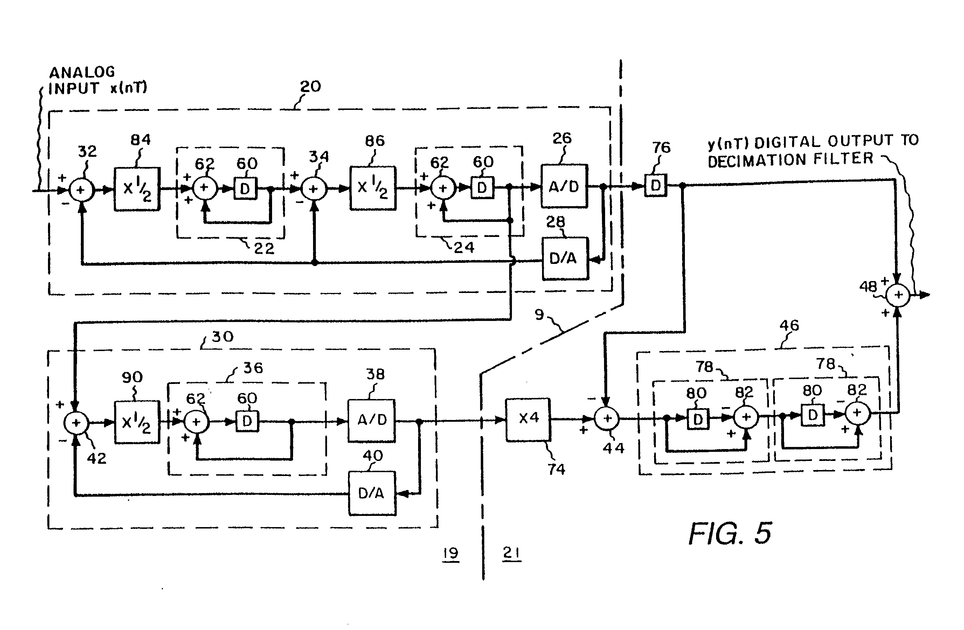

A specific implementation of the new third-order sigma-delta oversampled A/D converter network is shown in Figure 5, with L = 1, $k_{1a} = k_{1b} = k_2 = 1/2$, $j_1 = 1$ and $g_1 = 4$. Thus amplifiers 84 and 86 in second-order modulator 20 and amplifier 90 in first-order modulator 30 each have a gain coefficient of 1/2, and digital multiplier 74 has a multiplier coefficient of 4. (Amplifier 92 with a gain coefficient $j_1 = 1$ and amplifier 88 with a gain coefficient $2k_{1a}k_{1b} = 1/2$, employed in the circuit of Figure 4, are not shown in the circuit of Figure 5.) This implementation requires only one bit A/D and D/A converters.

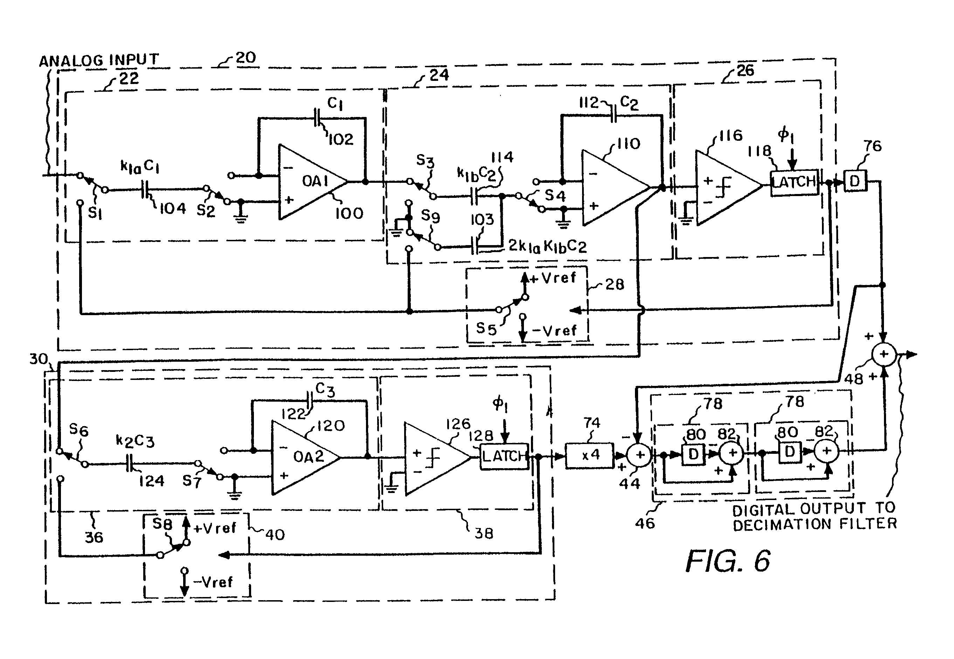

A switched capacitor implementation of the network of Figure 5 is shown in Figure 6 and employs a single-ended signal flow and stray-free integrators. Such integrators are described, for example, in R. Gregorian, "Analog MOS Integrated Circuits for Signal Processing", pp. 277-280, Wiley, New York, 1986, incorporated herein by reference. In second-order modulator 20, integrator 22 is embodied as a high gain differential amplifier (op amp) 100 provided with a feedback capacitor 102 and a switched input capacitor 104. A switch $S_1$ is provided for switching a capacitor 104 between the analog input signal and the feedback loop of modulator 20. A switch $S_2$ is provided for switching the output voltage of capacitor 104 between the two inputs of differential amplifier 100. Similarly, integrator 24 is embodied as a high gain differential amplifier (op amp) 110 provided with a feedback capacitor 112 and a pair of switched input capacitors 114 and 103. A switch $S_3$ is provided for switching capacitor 114 between the analog output signal from differential amplifier 100 and ground while a switch $S_9$ is provided for switching capacitor 103 between the feedback loop of modulator 20 and ground. A switch $S_4$ is provided for switching the output voltage of capacitors 114 and 103 between the two inputs of differential amplifier 110. A comparator 116 operated at a sampling rate $\phi_1$ converts the analog output signal from differential amplifier 110 into a binary output signal. This binary output signal is stored by a latch 118 and applied via a delay register 76 to the negative input of digital subtractor 44 and to digital adder 48. The output signal from latch 118 also controls a switch $S_5$ for switching the feedback loop between a positive reference voltage $+V_{ref}$ and a negative reference voltage $-V_{ref}$ depending on whether the polarity of the latched output signal from comparator 116 is positive or negative.

In first-order modulator 30, integrator 36 is embodied as a high gain differential amplifier (op amp) 120 provided with a feedback capacitor 122 and a switched input capacitor 124. A switch $S_6$ is provided for switching capacitor 124 between the analog output signal from differential amplifier 110 and the feedback loop of modulator 30. A switch $S_7$ is provided for switching the output voltage of capacitor 124 between the two inputs of differential amplifier 120. A comparator 126 operated on a sampling phase $\phi_1$ converts the analog output signal from differential amplifier 120 into a binary output signal. This binary output signal is stored by a latch 128, multiplied by four by multiplier 74, and applied to digital subtractor 44. The output signal of latch 128 also controls a switch $S_8$ for switching the feedback loop between a positive reference voltage $+V_{ref}$ and a negative reference voltage $-V_{ref}$ depending on whether polarity of the latched output signal from comparator 126 is positive or negative. The digital difference signal produced by digital subtractor 44 is differentiated twice by digital double differentiator 46 and the resultant differentiated signal is applied to digital adder 48. The switches, which may be implemented by metal-oxide-semiconductor switching devices, as known in the art, are all shown in a common phase $\phi_1$.

Switches $S_1$-$S_4$, $S_6$, $S_7$ and $S_9$ are analog switches controlled by clock phase signals $\phi_1, \phi_2$ which are derived from an oscillator or clock circuit (not shown). The clock signals are nonoverlapped and 180° out of phase.

When switches $S_1$-$S_4$, $S_6$, $S_7$ and $S_9$ are in the positions illustrated in Figure 6, capacitor 104 charges to the amplitude of the analog input signal while capacitor 114 charges to the output voltage of amp 100 and capacitor 124 charges to the output voltage of op amp 110. At the same time capacitor 103 is totally discharged.

Switches $S_5$ and $S_8$, both shown connected to a positive reference voltage, are controlled by the output signal of latch 118 and 128, respectively. Thus, when the latched value of the output signal of comparator 116 or 126 is high, switch $S_5$ or $S_8$, respectively, is connected to a positive reference voltage, and is connected to a negative reference voltage when the latched value of the output signal of comparator 116 or 126, respectively, is low.

Upon occurrence of phase $\phi_2$, the positions of switches $S_1$-$S_4$, $S_6$, $S_7$ and $S_9$ reverse from that shown in figure 6. Thus D/A converter 28 supplies a selected reference voltage through switch $S_5$, shown as being of positive polarity, which is added to the voltage on capacitor 104 and applied to the inverting input of amplifier 100. This input signal is integrated up in capacitor 102 until reoccurrence of clock phase $\phi_1$. At the same time, the previous (i.e., phase $\phi_1$) output voltage of amplifier 100, stored in capacitor 114, plus the reference voltage from switch $S_5$ which is now stored on capacitor 103, are supplied to the inverting input of amplifier 110, and the previous (i.e., phase $\phi_1$) output voltage of amplifier 110, stored on capacitor 124, is supplied to the inverting input of amplifier 120. Each of amplifiers 100, 110 and 120 thus performs an integration of the input voltage supplied to its respective inverting input terminal until phase $\phi_1$ again occurs.

If the signal at the input to comparator 116 is positive, switch $S_5$ is connected to the positive reference $+V_{ref}$ while if the signal is negative, switch $S_5$ is connected to the negative reference $-V_{ref}$. The signal at the comparator input is determined by an integration of a difference between the voltage developed on capacitors 103 and 114. The voltage on the output of integrator 22 is an integration of the difference between the input signal and either the positive or negative reference depending on the position of switch $S_5$. The output signal of integrator 22 can also be viewed as the integrated difference between the analog input signal and the digital representation of the analog input signal.

Integrator 22 acts as a noninverting integrator for the analog input signal, and as an inverting integrator for one-bit D/A converter 28 controlled by comparator 116. The output signal of integrator 22 changes every phase $\phi_2$ by an amount $(V_{in} - V_{D/A1})k_{1a}$, where $V_{D/A1}$ is the output voltage of D/A converter 28 while, during phase $\phi_1$, the output signal of integrator 22 remains held at the value established on the previous phase $\phi_2$. Integrator 36 operates in a similar manner, except that its input signal is the output signal of integrator 24 less the output signal of D/A converter 40; that is, the integrator 36 output signal changes every phase $\phi_2$ by an amount $(V2 - V_{D/A2})k_2$, where $V_2$ is the output voltage of integrator 36 and is held on phase $\phi_1$, and $V_{D/A2}$ is the output voltage of D/A converter 40.

The configuration of integrator 24 is slightly different from that of integrators 22 and 36 in that it uses separate capacitors 114 and 103 for its two input signals. This is necessary since different capacitor ratios are required for the two input signals to integrator 24. Specifically, the output signal of integrator 22 should be integrated with ratio $k_{1b}$ while the output signal of D/A converter 28 needs to be integrated with ratio $-2k_{1a}k_{1b}$, and therefore a combination of a noninverting and inverting switched capacitor integrator is employed as integrator 24. Through use of superposition, multiple input signals are accommodated by common connection at switch $S_4$ adjacent to the summing junction of op amp 110. Since each separate input capacitor 114 and 103 switches between ground and the op amp 110 negative input, switch $S_4$ can be shared, though individual switches $S_3$ and $S_9$ are needed for connection to the two input signals. The output signal of integrator 24 changes every phase $\phi_2$ by an amount $k_{1b}V_2 - 2k_{1a}k_{1b}V_{D/A2}$ and is held during phase $\phi_1$. In the circumstance that $k_{1a} = 1/2$, the two input capacitors 114 and 103 have the same value and a single capacitor may be used instead, as with integrators 22 and 36.

The circuit of Figure 6 is quite tolerant of capacitor mismatch errors. Each of the two switched capacitor integrators 22 and 36, respectively, employs a single switched capacitor 104 and 124, respectively, to take the difference of its two input signals. Therefore, the subtraction operation is-immune to error. The remaining switched capacitor integrator 24 uses separate switched capacitors 114 and 103 to take the difference of its two input signals; however, matching errors here are negligible when referred to the input. The other remaining summation or difference operations are implemented digitally and are also error free. The only component mismatch related error is the departure of the product $k_{1a}k_{1b}$ from equaling $1/j_1g_1$. This has the effect of leaking in the quantization noise from the first stage by the amount

$$[1 - j_1g_1/k_{1a}k_{1b})] (1-z^{-1})^2 E_1(z) \quad (4)$$

to make the overall output voltage $V_o(z)$ become

$$V_o(z) = z^{-3}V_i(z) + g_1(1 - z^{-1})^3 E_2(z) +$$
$$[1 - j_1g_1/(k_{1a}k_{1b})](1-z^{-1})^2 E_1(z) \quad (5)$$

where E1 represents the quantization noise of the first stage. Since the degree of mismatch, namely, $1 - j_1g_1/(k_{1a}k_{1b})$, multiplies a term that already has second-order noise shaping, i.e., $(1-z^{-1})^2 E_1(z)$, a relatively large error in $k_{1a}$ or $k_{1b}$ can be tolerated without undue degradation. For instance, it can be shown that a 5% error in the product $k_{1a}k_{1b}$ would raise the total quantization noise by less than 1 dB at an oversampling ratio of 64 to 1.

Extension simulations have been performed on a version of this new oversampled modulator. The parameters of the new analog-to-digital converter are as follows:

```
Third Order Sigma Delta ADC Parameters

Parameter                      Spec.    Units
Modulator Clock Rate           5.12     MHz
Oversampling Ratio              64
Voltage Reference              1.25     Volts
Resolution                      16      Bits
```

The simulation results are summarized below:

| Parameter | Value | Units |
|---|---|---|
| Conditions | | |
| Input Signal | 0.8 | Volts pk |
| Op Amp Gain | 1000 | |
| Op Amp Bandwidth | 80 | MHz |
| Op Amp Slew Rate | 200 | V/$\mu$s |
| Component Tolerance | 1 | % |
| Decimation Filter (using a comb filter) | sinc4 | |
| Ideal Performance | | |
| Harmonic Distortion | -145 | dB |
| Signal (Noise÷Distortion) | 101.2 | dB |
| Performance With Nonidealities | | |
| Harmonic Distortion | -125 | dB |
| Signal (Noise+Distortion) | 99.2 | dB |

The invention thus constitutes an improved modulator network that achieves third-order noise shaping and yet exhibits significantly reduced sensitivity to component matching and most other practical nonidealities. Simulations have shown that a 16-bit signal-to-noise ratio can be attained despite component matching of 2% and op amp gains of 1000. It is contemplated that integrated circuits containing this modulator can be manufactured with high yields, without trimming or calibration, and without any stringent process specifications. Thus the invention contemplates a high resolution, multi-channel analog-to-digital converter which can be economically achieved.

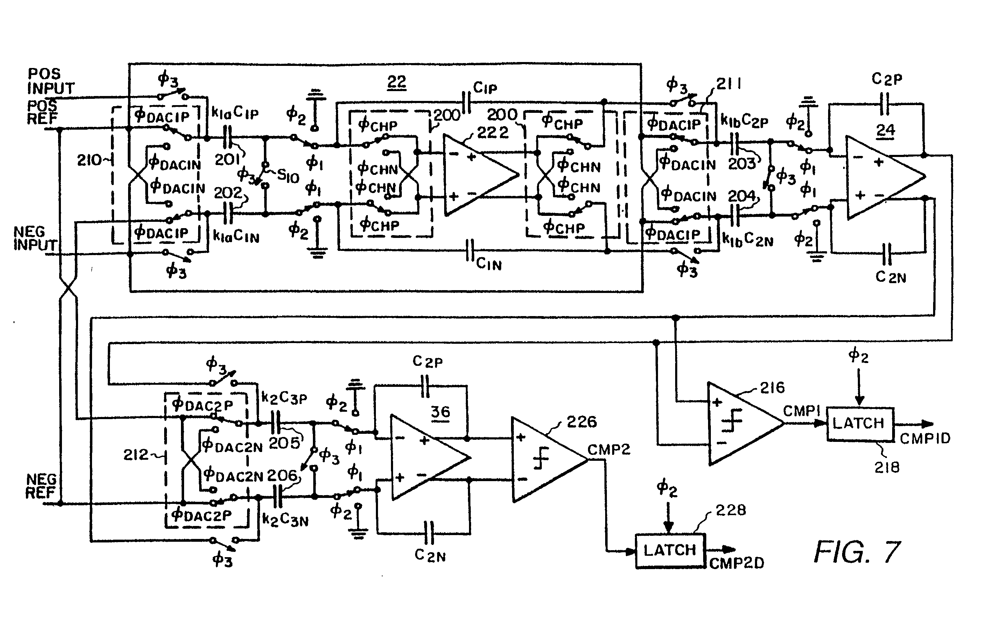

Although the modulator components, i.e., the integrators, the analog-to-digital converters, and the digital-to-analog converters, are so far illustrated with single-ended outputs, the third-order sigma-delta analog-to-digital converter of this invention can be implemented by employing a differential signal path using integrators with differential outputs for improved rejection of power supply noise. This is shown in Figure 7.

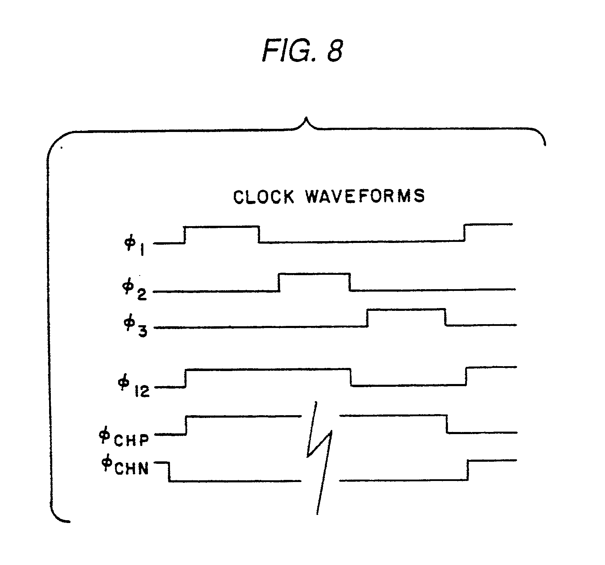

Figure 7 illustrates a network employing differential amplifiers which is representative of the circuitry used in a third-order sigma-delta oversampled A/D converter network test chip, while Figure 8 illustrates the clock waveforms employed in the circuit of Figure 7. The circuit of Figure 7 differs from the single-ended switched-capacitor A/D converter network shown in Figure 6 in that it uses three-phase instead of two-phase clocking, it makes use of a fully-balanced (or differential) signal path for better rejection of spurious power supply noise and common mode signals, it employs a chopper stabilization circuit 200 for suppression of low frequency op amp noise, and it can be operated as a single-ended input circuit even though it is a differential circuit. Each of integrators 22, 24 and 36 employed in the circuit of Figure 7 includes balanced outputs and balanced inputs.

In considering operation of the circuit of Figure 7, the presence of chopper 200 as part of integrator 22 will be ignored initially by assuming chopper phase $\phi_{CHP}$ is always asserted. A balanced input signal is also assumed. In these circumstances, operation is similar to that of the single-ended circuit of Figure 6 with the clock phases defined differently; i.e., clock phases $\phi_1$ and $\phi_2$ in the circuit of Figure 6 now correspond to phases $\phi_3$ and $\phi_1$, respectively. Operation is the same as described for Figure 6, if phase $\phi_2$ is temporarily ignored, except that when the input signal is sampled during phase $\phi_3$ by the two input capacitors 201 and 202, their output sides are connected together through switch $S_{10}$, instead of to ground. This connection is made so that only the differential component of the input signal is acquired. A common mode signal, if present, would also be sampled if capacitors 201 and 202 were switched to ground instead of to each other; however, in the configuration shown, the charge stored on input capacitors 201 and 202 depends only on the difference between the two input signals, not on their average value. Similar effects occur with regard to input capacitors 203 and 204 for the second stage integrator 24 of the network and input capacitors 205 and 206 for the third stage integrator 36 of the network.

As just described, the output sides of the input capacitors for each of the integrator stages would never be connected to a voltage source or ground, and hence the voltages on each of these capacitors would be arbitrary. Similarly, the voltage level at the input to the op amp receiving a signal from its input capacitors would be undefined. Therefore, to establish the potential at the output (or right-hand) side of the input capacitors, a connection to ground during phase $\phi_2$ is employed while the input (or left-hand) side of each input capacitor remains connected to receive the reference signals.

Another minor difference from the circuit of Figure 6 is that the one-bit D/A converters 210, 211 and 212 are implemented directly at the input (or left-hand) sides of input capacitors 201 and 202, 203 and 204, and 205 and 206, respectively, instead of by employing the single pole double-throw switches $S_5$ and $S_8$ shown in the network of Figure 6. The effect, however, is the same since the switches in each of D/A converters 210, 211 and 212 are controlled by a signal that is equal to the desired clock phase which is logically ANDed with the latched comparator signal. This implementation avoids need for a series connection of two switches and its associated speed penalty in high frequency circuit operation.

The logic for the individual switch positions in D/A converters 210, 211 and 212 is as follows:

$$\phi_{DAC1P} = \phi_{12} \quad * \quad CMP1D$$

$$\phi_{DAC1N} = \phi_{12} \quad * \quad \overline{CMP1D}$$

$$\phi_{DAC2P} = \phi_{12} \quad * \quad CMP2D$$

$$\phi_{DAC2N} = \phi_{12} \quad * \quad \overline{CMP2D}$$

where CMP1D and CMP2D are the output signals from comparator 216 at the output of second stage integrator 24, as latched by a latch circuit 218, and the output signals from comparator 226 at the output of third stage integrator 36, as latched by a latch circuit 228, respectively. Clock waveform $\phi_{12}$ is shown in Figure 8.

In considering the role of the chopper, the MOS switching devices represented by double-pole, double-throw switches 200 on either-side of the first op amp 222 perform a periodic reversal of signal polarities at the input and output of the op amp as controlled by the $\phi_{CHP}$ and $\phi_{CHN}$ chopper clock signals. Clocks $\phi_{CHP}$ and $\phi_{CHN}$, illustrated in the waveform drawings of Figure 8, may alternate at any rate that is an integer multiple of the output conversion rate, up to a maximum rate of the modulator frequency. When clock $\phi_{CHP}$ is high, a noninverting path through op amp 222 is selected by the chopper at both input and output, while when phase $\phi_{CHN}$ is high, an inverting configuration is produced. Since inversion takes place simultaneously at both the input and output of the op amp whenever clock $\phi_{CHN}$ is high, there is no effect on signals traversing the integrator. However, noise from the op amp itself goes through only the output switches of the chopper and, as such, alternates in polarity at a rate determined by the frequency of the chopper clocks. This is equivalent to multiplying the noise by a periodic square wave signal with an amplitude of ±1, which amounts to a modulation of the op amp noise up to the frequency of the chopper square wave and all of its harmonics. As a result, the severe low frequency flicker (or l/f) noise is moved out of the baseband frequency of the modulator. Flicker noise is discussed in R. Gregorian, "Analog MOS Integrated Circuits for Signal Processing", previously cited, at pages 500-505, and the discussion therein-is hereby incorporated by reference. Subsequent digital filtering by the decimation filter (not shown in Figure 7) removes the modulated 1/f noise. In fact, chopping at a rate equal to the output rate of the decimation filter or a higher integer multiple, places the fundamental and harmonics of the square wave at the frequencies of the zeros of the decimation filter (if a comb-type filter is used), facilitating removal of the modulated noise. Those skilled in the art will appreciate, however, that the invention is not limited to use of a digital decimation filter, and that any signal processing circuit capable of suppressing high frequency quantization noise components may be employed instead.

The inventor finds that the practical realization of this new A/D converter network, as well as the practical realization of other A/D converter networks of sigma-delta type that are being developed, is much enhanced by employing chopper stabilization of the operational amplifier used in the initial integrator for error signal. F. Yassa, S. Garverick, G. Ngo, R. Hartley, J. Prince, J. Lam, S. Noujaim, R. Korsunsky and J. Thomas in their paper entitled "A Multi-Channel Digital Demodulator for LVDT and RVDT Position Sensors" appearing on pages 20.5.1-20.5.5 of the IEEE 1989 CUSTOM INTEGRATED CIRCUITS CONFERENCE DIGEST OF TECHNICAL PAPERS, CH2671-6/89/0000-0125 $1.00 C. 1989 IEE describe the use of chopper stabilization in a sigma-delta (or delta-sigma) modulator to eliminate amplifier offset and component mismatch and to generate a dither signal which is added to the input to achieve higher sensitivity to low-amplitude signals. The zero of the decimation filter Yassa et al used after the sigma-delta modulator is matched to the frequency of the chopping signal, better to suppress the dither signal and other modulator artifacts produced at the chopping frequency. The chopper stabilization moves the flicker (or l/f) noise of the amplifier in the frequency spectrum from baseband to sidebands of the chopping frequency, the lower of which sidebands aliases into baseband to a degree. As long as high resolution is not demanded from the oversampling A/D converter network, the l/f noise aliased into the baseband is less than the difference between adjacent quantizing levels even if the frequency of the chopping signal in cycles per second is the same as the rate of the output from the decimation filter in samples per second.

As one strives for increased resolution in the digitized output, however, the l/f noise aliased into thebaseband becomes more than the difference between adjacent quantizing levels if the frequency of the chopping signal in cycles per second is the same as the rate of the output from the decimation filter in samples per second. The inventor finds that this problem is ameliorated if the chopping rate is increased to be a multiple, more than one, times the output rate from the decimation filter. Faster chopping rates introduce a tendency towards increased non-linearity arising from the settling of the chopper-stabilized amplifier after each switching thereof, the inventor finds. So, it is usually preferable not to increase the chopping rate to equal one half the oversampling rate. Rather, the inventor finds, it is usually preferable in an oversampling A/D converter network, from the standpoint of achieving the highest resolution in terms of bits, to choose the chopping rate to be a lower multiple of the rate of the output from the decimation filter. This lower multiple is preferably chosen as close as possible to where the characteristics associated with l/f noise and with the non-linearity arising from the settling of the chopper-stabilized amplifier after each switching thereof, respectively, exhibit their cross-over in values. Then, the difference between adjacent quantizing levels can be minimized to make available the most number of bits of resolution.

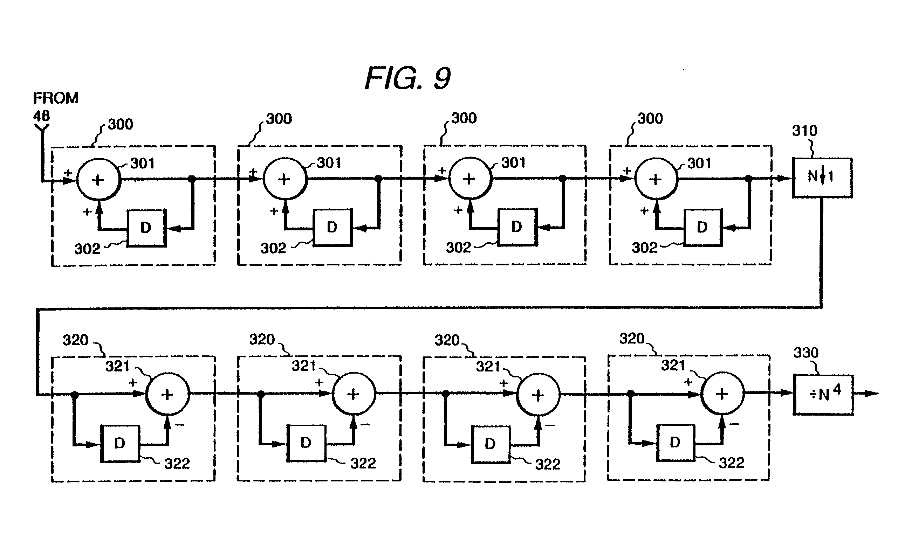

Figure 9 shows a form the digital decimation filter 50 of Figure 3 may take. Figure 9 shows a comb filter of the since type of the type described by E. Dijkstra, O. Nye, C. Piguet and M. Degrauwe in their Paper "On the Use of Modulo Aritthmetic Comb Filters in Sigma Delta Modulators" in pages 2001-2004 of the PROCEEDINGS OF THE IEEE CONFERENCE ON ACOUSTICS, SPEECH & PROCESSING, 1988. The Figure 3 third-order sigma-delta analog-to-digital converter network shapes its quantization noise spectrum with a sixth-order sinusoidal characteristic

$$S_N(\omega T) = k_{QN} [2 \sin(\omega T/2)]^{2L}$$

where $k_{QN}$ is the power-spectral density (PSD) of the unshaped (white) quantization noise and L=3 is the order of the sigma-delta modulator. A comb filter of the $\mathrm{sinc}^n$ type can adequately suppress this quantization noise, if n exceeds L by one. The Figure 9 comb filter, wherein n equals four, will adequately suppress the $k_{QN} [2 \sin(\omega T/2)]^6$ quantization noise in the sum output signal of the adder 48 in the third-order sigma-delta analog-to-digital converter network of Figure 3.

The Figure 9 comb filter receives as its input signal the sum output signal from the digital adder 48 of the Figure 3, 4 or 5 sigma-delta modulator to be quadruply integrated in a cascade of n integrators, n equalling four in the Figure 9 comb filter, each integrator 300 comprising a respective digital adder 301 and a respective delay register 302 for feeding back the sum output of the adder 301 to an input thereof. In a decimation procedure, the quadruply integrated response of this cascade is subsampled n:1 in a digital sampler 310 as may be provided by a plural-bit latch. The subsampled response of the digital sampler 310 is quadruply differentiated in a cascade of n differentiators, n equalling four in the Figure 9 comb filter, each differentiator 320 shown as comprising a digital adder 321 for adding together the current sample of differentiator 320 input signal to the previous sample as stored in a delay register 322, thereby to generate a sum output signal that is the derivative respective to time of the differentiator 320 input signal. The response from the final differentiator 320 is scaled down in amplitude by $n^n$ in a digital scaler 330 is the ultimate decimation filter 50 response.

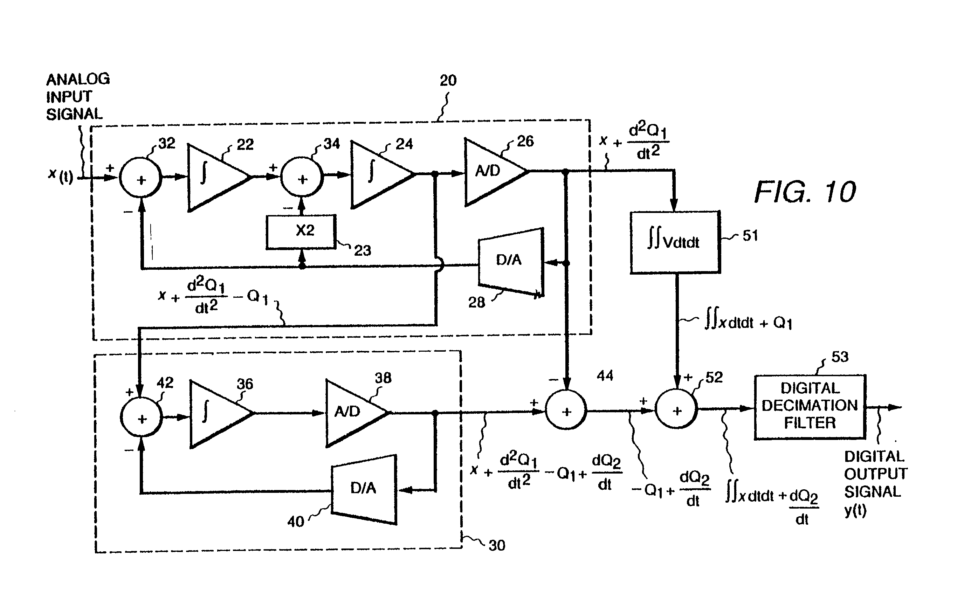

Figure 10 shows a variant of the Figure 3 third-order sigma-delta analog-to-digital converter network, which variant is an alternative embodiment of the invention. Rather than doubly differentiating the subtractor 44 difference output signal with respect to time and adding the result to the second-order modulator 20 output signal to cancel the quantization noise from the second-order modulator 20, the second-order modulator 20 output signal is doubly integrated in a digital double integrator 51, and the response of digital double integrator 51 is added in an digital adder 52 to the second-order modulator 20 output signal. The sum output signal from adder 52 includes a low-pass filtered (twice integrated) digitization of analog input signal plus first-order quantization noise from the first-order modulator 30. The quantization noise from the second-order modulator 20 does not appear in the sum output signal from adder 52, which is supplied to a digital decimation filter 53 that responds with a digital output signal y(t).

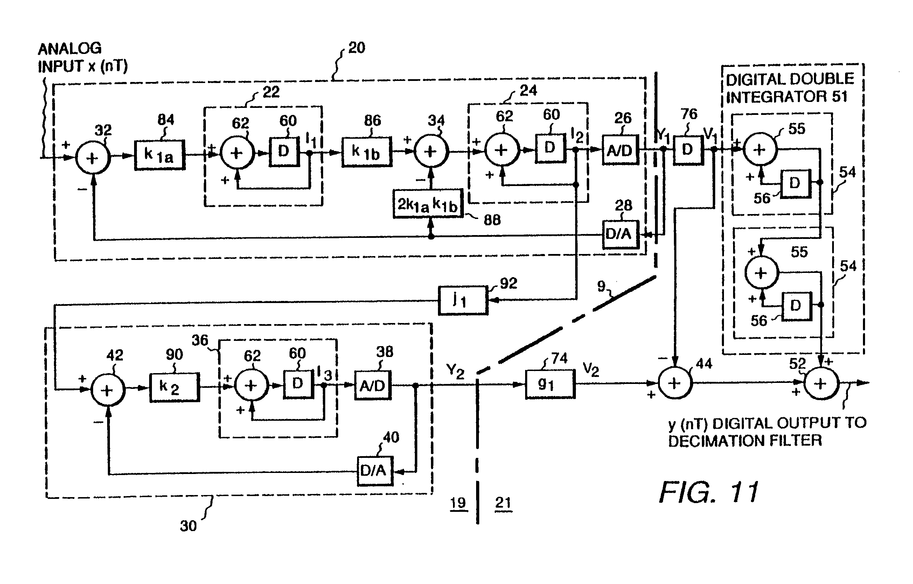

Figure 11 shows a variant of the Figure 4 third-order sigma-delta analog-to-digital converter network, which variant is an alternative embodiment of the invention and is of the type shown generally in figure 10. The digital double integrator 51 is shown more particularly in Figure 10 as a pair of cascaded integrators 54, each integrator 54 comprising a digital adder 55 and a delay register 56 for feeding back the sum output of the adder 55 to an input thereof.

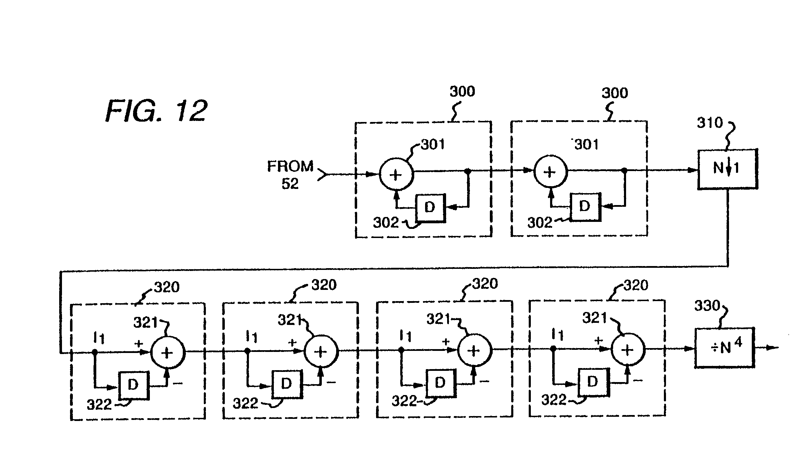

Figure 12 shows a form the digital decimation filter 53 can take. The digital decimation filter 53, connected to receive as its input signal the sum output signal from the digital adder 52 of Figure 10 or 11, supplies the same response as the digital decimation filter 50, connected to receive as its input signal the sum output signal from the digital adder 48 of Figure 3 or 4. The leading two integrators 300 of the digital decimation filter 50 are dispensed with in the digital decimation filter 53, which is possible owing to the Figure 10 or 11 third-order sigma-delta analog-to-digital converter network having the digital double integrator 51 for the output signal of the second-order modulator 20 and not having the digital double differentiator 46 for the output signal from the digital subtractor 44.

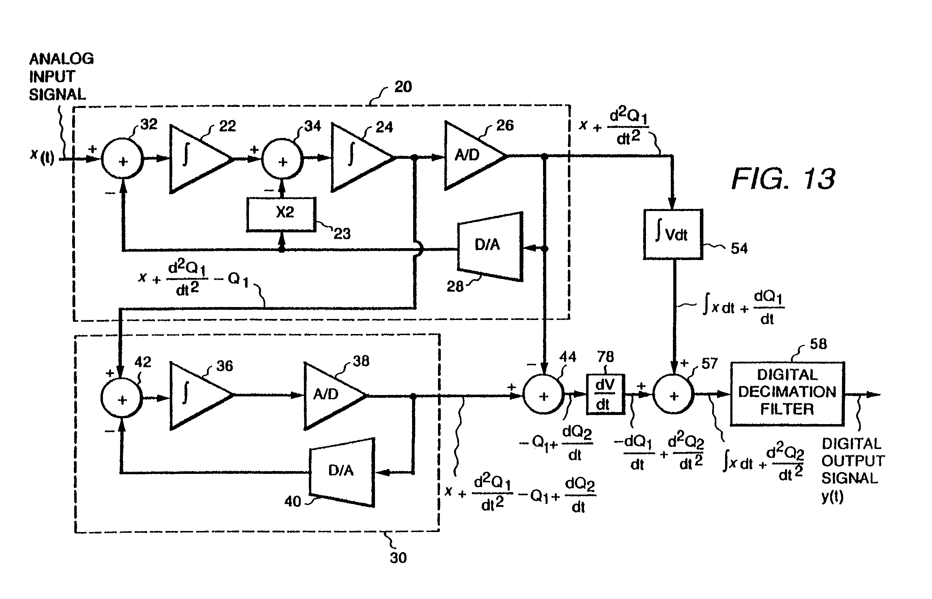

Figure 13 shows variant of the figure 3 and Figure 10 third-order sigma-delta analog-to-digital converter networks, which variant is another alternative embodiment of the invention. The subtractor 44 difference output signal is differentiated only once with respect to time in a single digital integrator 78, the second-order modulator 20 output signal is integrated only once in a digital integrator 54, and the responses of of digital integrator 78 and digital integrator 54 are added together in an digital adder 57. The sum output signal from adder 57 includes a low-pass filtered (once integrated) digitization of analog input signal plus second-order quantization noise from the first-order modulator 30. The quantization noise from the second-order modulator 20 does not appear in the sum output signal from adder 57, which is supplied to a digital decimation filter 58 that responds with a digital output signal y(t).

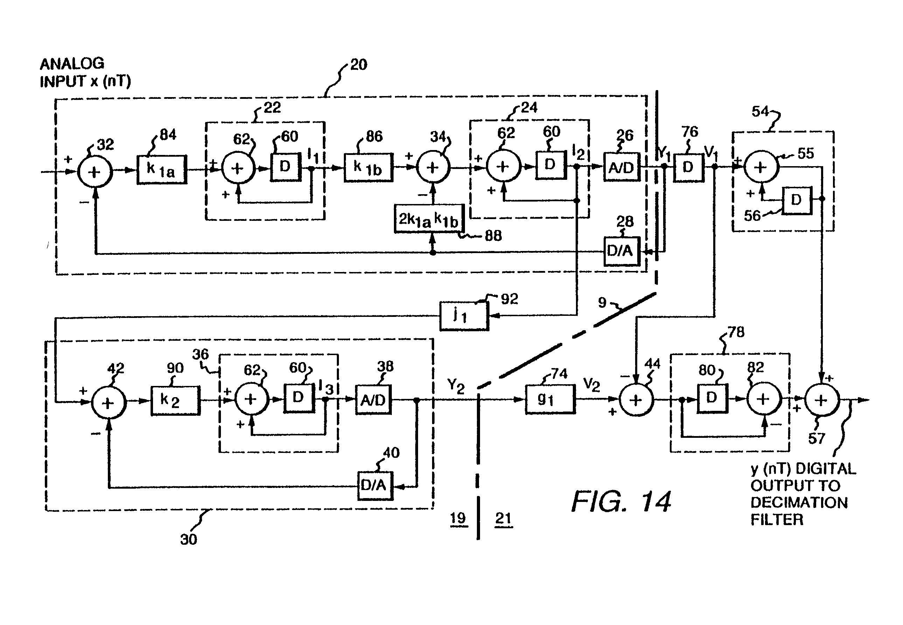

Figure 14 shows a variant of the third-order sigma-delta analog-to-digital converter networks of figure 4 and figure 11, which variant is an alternative embodiment of the invention and is of the type shown generally in figure 13. The differentiator 78 is shown as comprising a digital adder 82 for adding together the current sample of difference signal from subtractor 44 to the previous sample as stored in a delay register 80, thereby to generate a sum output signal that is the derivative respective to time of the difference signal from subtractor 44. The integrator 54 is shown as comprising a digital adder 55 and a delay register 56 for feeding back the sum output of the adder 55 to an input thereof.

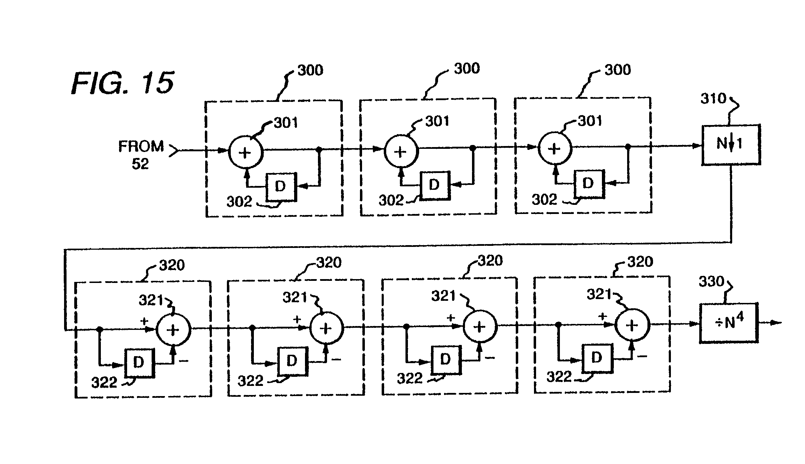

Figure 15 shows a form the digital decimation filter 58 can take. The digital decimation filter 58, connected to receive as its input signal the sum output signal from the digital adder 52 of Figure 13 or 14, supplies the same response as the digital decimation filter 50, connected to receive as its input signal the sum output signal from the digital adder 48 of figure 3 or 4. The leading integrator 300 of the digital decimation filter 50 is dispensed with in the digital decimation filter 58, which is possible owing to the Figure 13 or 14 third-order sigma-delta analog-to-digital converter network having the digital integrator 54 for the output signal of the second-order modulator 20 and having only the single digital differentiator 78 for the output signal from the digital subtractor 44.

## Claims

1. A third-order sigma-delta analog-to-digital converter network, comprising:

a second-order modulator comprising first and second integrators coupled in cascade such that the output of said first integrator is coupled to the input of said second integrator, said first integrator being adapted to receive an analog input signal, and a first analog-to-digital converter coupled to the output of said second integrator, said first analog-to-digital converter being adapted to convert an analog output signal from said second integrator into a first digital output signal corresponding to said analog input signal plus a second-order differential quantization noise component, said analog output signal corresponding to said first digital output signal less quantization noise of said second-order modulator;

a first-order modulator comprising a third integrator, means coupling the output of said second integrator to the input of said third integrator, and a second analog-to-digital converter coupled to the output of said third integrator for converting said analog output signal of said second integrator into a second digital output signal corresponding to said analog output signal plus a first-order differential quantization noise component; and

means for combining said first and second digital output signals of said second-order and first-order modulators to generate a digital output signal corresponding to said analog input signal essentially free of quantization noise from said second-order modulator.

2. The third-order sigma-delta analog-to-digital converter network of claim 1, including, within said means for combining said first and second digital output signals of said second-order and first-order modulators to generate a digital output signal corresponding to said analog input signal essentially free of quantization noise from said second-order modulator:

digital subtractor means coupled to the outputs of said first and second analog-to-digital converters for providing a digital difference signal representative of the difference between the output signals of said first and second analog-to-digital converters.

3. The third-order sigma-delta analog-to-digital converter network of claim 2, further including, within said means for combining said first and second digital output signals of said second-order and first-order modulators to generate a digital output signal corresponding to said analog input signal essentially free of quantization noise from said second-order modulator:

a digital double differentiator coupled to the output of said digital subtractor means for double differentiating said digital difference signal;

digital adder means coupled to the outputs of said first analog-to-digital converter and said digital double differentiator for adding the output signal of said first analog-to-digital converter to the output signal of said digital double differentiator; and

digital decimation filter means coupled to the output of said digital adder means for suppressing any triple differentiated quantization noise from the output signal of said digital adder means.

4. The third-order sigma-delta analog-to-digital converter network of claim 2, further including, within said means for combining said first and second digital output signals of said second-order and first-order modulators to generate a digital output signal corresponding to said analog input signal essentially free of quantization noise from said second-order modulator:

a digital double integrator coupled to the output of said first analog-to-digital converter for double integrating the output signal of said first analog-to-digital converter;

digital adder means coupled to the outputs of said digital subtractor means and said digital double integrator for adding the output signal of said digital subtractor means to the output signal of said digital double integrator; and

digital decimation filter means coupled to the output of said digital adder means for suppressing any triple differentiated quantization noise from the output signal of said digital adder means.

5. The third-order sigma-delta analog-to-digital converter network of claim 2, further including, within said means for combining said first and second digital output signals of said second-order and first-order modulators to generate a digital output signal corresponding to said analog input signal essentially free of quantization noise from said second-order modulator:

a digital differentiator coupled to the output of said digital subtractor means for differentiating said digital difference signal;

a digital integrator coupled to the output of said first analog-to-digital converter for integrating the output signal of said first analog-to-digital converter;

digital adder means coupled to the outputs of said digital differentiator and said digital integrator for adding the output signal of said digital differentiator to the output signal of said digital integrator; and

digital decimation filter means coupled to the output of said digital adder means for suppressing any triple differentiated qantization noise from the output signal of said digital adder means.

6. The third-order sigma-delta analog-to-digital converter network of claim 1, wherein:

said second-order modulator includes a first digital-to-analog converter coupled in first and second feedback loops between the output of said first analog-to-digital converter and the inputs of said first and second integrators, respectively, and

said first-order modulator includes a second digital-to-analog converter coupled in a third feedback loop between the output of said second analog-to-digital converter and the input of said third integrator.

7. The third-order sigma-delta analog-to-digital converter network of claim 6, including, within said means for combining said first and second digital output signals of said second-order and first-order modulators to generate a digital output signal corresponding to said analog input signal essentially free of quantization noise from said second-order modulator:

digital subtractor means coupled to the outputs of said first and second analog-to-digital converters for providing a digital difference signal representative of the difference between the output signals of said first and second analog-to-digital converters.

8. The third-order sigma-delta analog-to-digital converter network of claim 7, further including, within said means for combining said first and second digital output signals of said second-order and first-order modulators to generate a digital output signal corresponding to said analog input signal essentially free of quantization noise from said second-order modulator:

a digital double differentiator coupled to the output of said digital subtractor means for double differentiating said digital difference signal;

digital adder means coupled to the outputs of said first analog-to-digital converter and said digital double differentiator for adding the output signal of said first analog-to-digital converter to the output signal of said digital double differentiator; and

digital decimation filter means coupled to the output of said digital adder means for suppressing any triple differentiated quantization noise from the output signal of said digital adder means.

9. The third-order sigma-delta analog-to-digital converter network of claim 7, further including, within said means for combining said first and second digital output signals of said second-order and first-order modulators to generate a digital output signal corresponding to said analog input signal essentially free of quantization noise from said second-order modulator:

a digital double integrator coupled to the output of said first analog-to-digital converter for double integrating the output signal of said first analog-to-digital converter;

digital adder means coupled to the outputs of said digital subtractor means and said digital double integrator for adding the output signal of said digital subtractor means to the output signal of said digital double integrator; and

digital decimation filter means coupled to the output of said digital adder means for suppressing any triple differentiated quantization noise from the output signal of said digital adder means.

10. The third-order sigma-delta analog-to-digital converter network of claim 7, further including, within said means for combining said first and second digital output signals of said second-order and first-order modulators to generate a digital output signal corresponding to said analog input signal essentially free of quantization noise from said second-order modulator:

a digital differentiator coupled to the output of said digital subtractor means for differentiating said digital difference signal;

a digital integrator coupled to the output of said first analog-to-digital converter for integrating the output signal of said first analog-to-digital converter;

digital adder means coupled to the outputs of said digital differentiator and said digital integrator for adding the output signal of said digital differentiator to the output signal of said digital integrator; and

digital decimation filter means coupled to the output of said digital adder means for suppressing any triple differentiated quantization noise from the output signal of said digital adder means.

11. The third-order sigma-delta analog-to-digital converter network of claim 6 wherein said means coupling the output of said second integrator to the input of said third integrator comprises an amplifier of gain $j_1$, said network further including:

a digital multiplier coupled to the output of said second analog-to-digital converter for multiplying said second digital output signal by a digital multiplier coefficient $g_1$;

said second-order modulator further including first circuit means having an analog scaling coefficient $k_{1a}$ for scaling the signal supplied to said first integrator and second circuit means having an analog scaling coefficient $k_{1b}$ for scaling the output signal of said first integrator.

12. The third-order sigma-delta analog-to-digital converter network of claim 11 wherein said first-order modulator further includes:

subtractor means coupled to the output of said amplifier of gain $j_1$ and to the output of said second digital-to-analog converter; and

third circuit means having an analog scaling coefficient $k_2$ for supplying a scaled version of the analog output signal of said subtractor means to said third integrator.

13. The third-order sigma-delta analog-to-digital converter network of claim 7 wherein said means coupling the output of said second integrator to the input of said third integrator comprises an amplifier of gain $j_1$, said network further including:

a digital multiplier coupled to the output of said second analog-to-digital converter for multiplying said second digital output signal by a coefficient $g_1$;

said first integrator having an analog scaling coefficient $k_{1a}$ for scaling the output signal thereof;

said first feedback loop further including first subtractor means responsive to said analog input signal and the output signal of said first digital-to-analog converter, and first circuit means having an analog scaling coefficient $k_{1a}$ for supplying the scaled-output signal of said subtractor means to said first integrator;

said second feedback loop further including an analog scaling coefficient $2k_{1a}k_{1b}$ for scaling the output signal of said first digital-to-analog converter and second subtractor means having one input responsive to the scaled output signal of said first digital-to-analog converter, said cascade coupling of said first and second integrators including said second subtractor means and an analog scaling coefficient $k_{1b}$ for scaling the output signal of said first integrator and for applying the scaled output signal of said first integrator to a second input of said second subtractor means, the output of said second subtractor means being coupled to the input of said second integrator;

said coefficients being related according to $j_1 g_1 = 1/k_{1a}k_{1b}$.

14. The third-order sigma-delta analog-to-digital converter network of claim 13 wherein each of said first, second and third integrators, respectively, comprises an analog adder for receiving an input signal at a first input thereof, and a delay register coupled to the output of said analog adder, the output of said delay register being coupled in a feedback configuration to a second input of said analog adder.

15. The third-order sigma-delta analog-to-digital converter network of claim 1 wherein each of said first, second and third integrators, respectively, includes balanced inputs and balanced outputs.

16. The third-order sigma-delta analog-to-digital converter of Claim 1 wherein said first integrator is of a type that includes a chopper-stabilized amplifier in which chopping of input and output signals is done at a prescribed chopping rate and includes output to input feedback capacitance.

17. The third-order sigma-delta analog-to-digital converter of Claim 17 in combination with:

a decimation filter for comb-filtering said digital output signal from the means for combining said first and second digital signals, said decimation filter having zeroes at said chopping rate and its harmonics.

18. A third-order sigma-delta analog-to-digital converter network comprising:

a second-order modulator responsive to an analog input signal for generating a first digital output signal corresponding to the analog input signal plus a second-order differential quantization noise component and for generating an analog output signal corresponding to said first digital output signal less quantization noise of said second-order modulator;

a first-order modulator responsive to said analog output signal of said second-order modulator for generating a second digital output signal corresponding to said analog output signal plus a first-order differential quantization noise component;

a digital subtractor for determining the difference between said first and second digital output signals to produce a digital difference signal comprising a first-order noise component from said first-order modulator less the quantization noise from said second-order modulator;

a digital double differentiator for twice differentiating said digital difference signal to produce a resultant digital signal including a third-order differential quantization noise component from said first-order modulator less a second-order differential quantization noise component from said second-order modulator;

a digital adder for adding said first digital output signal and said resultant digital signal to produce a third digital output signal in which the first-order and second-order differential noise components have been eliminated; and

a digital decimation filter for suppressing the third-order differential noise component from said third digital output signal.

19. The third-order sigma-delta analog-to-digital converter network of claim 18, wherein:

said digital double differentiator comprises a pair of digital differentiators coupled in cascade, each of said differentiators, respectively, comprising a delay register and a digital subtractor having a first input coupled to the output of said delay register and a second input coupled to the input of said delay register.

20. The third-order sigma-delta analog-to-digital converter network of claim 19, wherein:

said second-order modulator comprises first and second integrators coupled in cascade such that the output of said first integrator is coupled to the input of said second integrator, and an analog-to-digital converter coupled to the output of said second integrator, said analog-to-digital converter being adapted to convert an analog output signal from said second integrator into said first digital output signal; and

said first-order modulator comprises a third integrator having an input coupled to the output of said second integrator and a second analog-to-digital converter coupled to the output of said third integrator for converting the analog output signal of said second integrator into said second digital output signal.

21. A third-order sigma-delta analog-to-digital converter network comprising:

first and second integrators coupled in cascade such that the output of said first integrator is coupled to the input of said second integrator;

a first comparator coupled to the output of said second integrator for providing a first digital output signal;

a first switched reference voltage source;

means coupling said first switched reference voltage source to the output of said first comparator, said first integrator being responsive to an analog input signal and to said first switched reference source in order to provide a first analog output signal to said second integrator, said second integrator being responsive to said first analog output signal and to said first switched reference source in order to provide a selected analog output signal to said first comparator, said first comparator being responsive to said selected analog output signal to provide said first digital output signal;

a third integrator coupled to the output of said second integrator;

a second comparator coupled to the output of said third integrator for providing a second digital output signal;

a second switched reference voltage source;

means coupling said second switched reference voltage source to the output of said second comparator, said third integrator being responsive to said selected analog output signal and to said second switched reference source to provide a second selected analog output signal to said second comparator, said second comparator being responsive to said second selected analog output signal to produce said second digital output signal;

a digital multiplier for multiplying said second digital output signal by a multiplier coefficient;

a digital subtractor coupled to said digital multiplier and said first comparator for providing a digital difference signal therebetween;

a digital double differentiator coupled to said digital subtractor for twice differentiating said digital difference signal to produce a resultant digital signal;

a digital adder for adding said first digital output signal and said resultant digital signal to produce a third digital output signal; and

a digital decimation filter responsive to said third digital output signal for producing a digital representation of said analog input signal.

22. The third-order sigma-delta analog-to-digital converter network of claim 21 wherein each of said first, second and third integrators comprises, respectively:

a differential amplifier having first and second inputs and an output;

a feedback capacitor connected between said output and said first input;

an input capacitor; and

switching means for selectively connecting said input capacitor to a received analog voltage or to a reference voltage so as to charge or discharge said input capacitor, and for selectively connecting said input capacitor to said first input when said input capacitor is connected to said reference voltage.

23. The third-order sigma-delta analog-to-digital converter of claim 21, wherein said digital double differentiator comprises a pair of digital differentiators in cascade connection, each of said differentiators respectively comprising:

a respective delay register and

a respective digital subtractor having a first input coupled to the output of its said respective delay register and a second input coupled to the input of its said respective delay register.

24. The third-order sigma-delta analog-to-digital converter network of claim 21 wherein said means coupling said first switched reference voltage source to the output of said first comparator comprises a first latch for storing said first digital output signal and wherein said means coupling said second switched reference voltage source to the output of said second comparator comprises a second latch for storing said second digital output signal, said first latch coupling said digital subtractor to said first comparator.

18

**25.** A third-order sigma-delta analog-to-digital converter network comprising:

first and second integrators coupled in cascade such that the output of said first integrator is coupled to the input of said second integrator;

a first comparator coupled to the output of said second integrator for providing a first digital output signal;

a first switched reference voltage source;

means coupling said first switched reference voltage source to the output of said first comparator, said first integrator being responsive to an analog input signal and to said first switched reference source in order to provide a first analog output signal to said second integrator, said second integrator being responsive to said first analog output signal and to said first switched reference source in order to provide a selected analog output signal to said first comparator, said first comparator being responsive to said selected analog output signal to provide said first digital output signal;

a third integrator coupled to the output of said second integrator;

a second comparator coupled to the output of said third integrator for providing a second digital output signal;

a second switched reference voltage source;

means coupling said second switched reference voltage source to the output of said second comparator, said third integrator being responsive to said selected analog output signal and to said second switched reference source to provide a second selected analog output signal to said second comparator, said second comparator being responsive to said second selected analog output signal to produce said second digital output signal;

a digital multiplier for multiplying said second digital output signal by a multiplier coefficient;

a digital subtractor coupled to said digital multiplier and said first comparator for providing a digital difference signal therebetween;

a digital double integrator for twice integrating said first digital output signal to produce a resultant digital signal;

a digital adder for adding said digital difference signal and said resultant digital signal to produce a third digital output signal; and

a digital decimation filter responsive to said third digital output signal for producing a digital representation of said analog input signal.

**26.** The third-order sigma-delta analog-to-digital converter network of claim 25 wherein each of said first, second and third integrators comprises, respectively:

a differential amplifier having first and second inputs and an output;

a feedback capacitor connected between said output and said first input;

an input capacitor; and

switching means for selectively connecting said input capacitor to a received analog voltage or to a reference voltage so as to charge or discharge said input capacitor, and for selectively connecting said input capacitor to said first input when said input capacitor is connected to said reference voltage.

**27.** The third-order sigma-delta analog-to-digital converter of claim 26, wherein said digital double integrator comprises a pair of digital integrators in cascade connection, each of said digital integrators respectively comprising:

a respective delay register and

a respective digital adder having a first input, a second input coupled to the output of its said respective delay register, and an output coupled to the input of its said respective delay register.

**28.** The third-order sigma-delta analog-to-digital converter network of claim 25 wherein said means coupling said first switched reference voltage source to the output of said first comparator comprises a first latch for storing said first digital output signal and wherein said means coupling said second switched reference voltage source to the output of said second comparator comprises a second latch for storing said second digital output signal, said first latch coupling said digital subtractor to said first comparator.

**29.** A third-order sigma-delta analog-to-digital converter network comprising:

first and second integrators coupled in cascade such that the output of said first integrator is coupled to the input of said second integrator;

a first comparator coupled to the output of said second integrator for providing a first digital output signal;

19

a first switched reference voltage source;

means coupling said first switched reference voltage source to the output of said first comparator, said first integrator being responsive to an analog input signal and to said first switched reference source in order to provide a first analog output signal to said second integrator, said second integrator being responsive to said first analog output signal and to said first switched reference source in order to provide a selected analog output signal to said first comparator, said first comparator being responsive to said selected analog output signal to provide said first digital output signal;

a third integrator coupled to the output of said second integrator;

a second comparator coupled to the output of said third integrator for providing a second digital output signal;

a second switched reference voltage source;

means coupling said second switched reference voltage source to the output of said second comparator, said third integrator being responsive to said selected analog output signal and to said second switched reference source to provide a second selected analog output signal to said second comparator, said second comparator being responsive to said second selected analog output signal to produce said second digital output signal;

a digital multiplier for multiplying said second digital output signal by a multiplier coefficient;

a digital subtractor coupled to said digital multiplier and-said first comparator for providing a digital difference signal therebetween;

a digital differentiator coupled to said digital subtractor for once differentiating said digital difference signal to produce a resultant differentiated digital signal;

a digital integrator for once integrating said first digital output signal to produce a resultant integrated digital signal;

a digital adder for adding said resultant differentiated digital signal and said resultant integrated digital signal to produce a third digital output signal; and

a digital decimation filter responsive to said third digital output signal for producing a digital representation of said analog input signal.

30. The third-order sigma-delta analog-to-digital converter network of claim 24 wherein each of said first, second and third integrators comprises, respectively:

a differential amplifier having first and second inputs and an output;

a feedback capacitor connected between said output and said first input;

an input capacitor; and

switching means for selectively connecting said input capacitor to a received analog voltage or to a reference voltage so as to charge or discharge said input capacitor, and for selectively connecting said input capacitor to said first input when said input capacitor is connected to said reference voltage.

31. The third-order sigma-delta analog-to-digital converter of claim 30, wherein said digital differentiator comprises:

a respective delay register and

a digital subtractor having a first input coupled to the output of its said respective delay register and a second input coupled to the input of its said respective delay register; and wherein said digital integrator comprises:

a respective delay register and

a digital adder having a first input, a second input coupled to the output of its said respective delay register, and an output coupled to the input of its said respective delay register.

32. The third-order sigma-delta analog-to-digital converter network of claim 29 wherein said means coupling said first switched reference voltage source to the output of said first comparator comprises a first latch for storing said first digital output signal and wherein said means coupling said second switched reference voltage source to the output of said second comparator comprises a second latch for storing said second digital output signal, said first latch coupling said digital subtractor to said first comparator.

33. In an oversampling analog-to-digital converter having a sigma-delta modulator followed in cascade by a decimation filter; the decimation filter supplying digital output signals for said oversampling analog-to-digital converter at an output rate that is a submultiple 1/R of an oversampling rate at which digital samples of an input signal for said decimation filter are supplied, R being an integer at least four; the sigma-delta modulator having therewithin a chopper-stabilized amplifier connected as a Miller integrator for generating an

20

integrator output signal that is the time integral of an error signal, means for quantizing said integrator output signal to generate at an oversampling rate digital samples of the input signal for said decimation filter, a digital-to-analog converter for generating an analog feedback signal corresponding to the digitized input signal for said decimation filter, and means for differentially combining said analog feedback signal with an analog input signal for said oversampling analog-to-digital converter thereby to generate said error signal; an improvement comprising:

means for operating said chopper-stabilized amplifier at a chopping rate lower than half said oversampling rate and higher than said output rate.

34. In an oversampling analog-to-digital converter having a sigma-delta modulator followed in cascade by a decimation filter; the decimation filter supplying digital output signals for said oversampling analog-to-digital converter at an output rate that is a submultiple $1/R$ of an oversampling rate at which digital samples of an input signal for said decimation filter are supplied, R being an integer at least four; the sigma-delta modulator having therewithin a chopper-stabilized amplifier connected as a Miller integrator for generating an integrator output signal that is the time integral of an error signal, means for quantizing said integrator output signal to generate at an oversampling rate digital samples of the input signal for said decimation filter, a digital-to-analog converter for generating an analog feedback signal corresponding to the digitized input signal for said decimation filter, and means for differentially combining said analog feedback signal with an analog input signal for said oversampling analog-to-digital converter thereby to generate said error signal; an improvement wherein the chopping rate in said chopper-stabilized amplifier is chosen so the $1/f$ noise and the non-linearity arising from the settling of the chopper-stabilized amplifier after each switching thereof are of the same order of amplitude in the frequency baseband, thus to make available more bits of resolution from said oversampling analog-to-digital converter.

RATE $F_M$

RATE $F_M$

RATE $F_M$

RATE $F' = \dfrac{F_M}{N}$

10

12

14

$x(n)$

(a)

OVER SAMPLED
INTERPOLATING
MODULATOR

$u(n)$

(b)

LOW PASS
DECIMATION
FILTER
$h(n)$

(c)

$w(n)$

(d)

SAMPLING-RATE
COMPRESSOR

$\downarrow N$

(e)

$y(n)$

## FIG. 1

(PRIOR ART)

$X(f)$

$F_S$

$U(f)$

$F_S$   $\dfrac{F_M}{2}$   f

$H(f)$

$\dfrac{F_M}{N}$   $\dfrac{F_M}{2}$   f

$W(f)$

$F_S$  $\dfrac{F_M}{N}$  $\dfrac{F_M}{2}$   f

$Y(f)$

$F_S$   $\dfrac{F_M}{N}$   $\dfrac{2F_M}{N}$   f
$= F'$   $= 2F'$

*FIG. 2(a)*   *FIG. 2(b)*   *FIG. 2(c)*   *FIG. 2(d)*   *FIG. 2(e)*

(PRIOR ART)

FIG. 3

FIG. 4

FIG. 5

ANALOG INPUT x(nT)

y(nT) DIGITAL OUTPUT TO DECIMATION FILTER

EP 0 450 951 A2

FIG. 6

EP 0 450 951 A2

FIG. 7

# FIG. 8

CLOCK WAVEFORMS

$\phi_1$

$\phi_2$

$\phi_3$

$\phi_{12}$

$\phi_{CHP}$

$\phi_{CHN}$

FIG. 9

EP 0 450 951 A2

*FIG. 10*

ANALOG INPUT x (nT)

DIGITAL DOUBLE INTEGRATOR 51

y (nT) DIGITAL OUTPUT TO DECIMATION FILTER

*FIG. 11*

## FIG. 12

FIG. 13

ANALOG INPUT SIGNAL

$x + \dfrac{d^2Q_1}{dt^2}$

$x + \dfrac{d^2Q_1}{dt^2} - Q_1$

$\displaystyle\int x\,dt + \dfrac{dQ_1}{dt}$

$x + \dfrac{d^2Q_1}{dt^2} - Q_1 + \dfrac{dQ_2}{dt}$

$-Q_1 + \dfrac{dQ_2}{dt}$

$-\dfrac{dQ_1}{dt} + \dfrac{d^2Q_2}{dt^2}$

$\displaystyle\int x\,dt + \dfrac{d^2Q_2}{dt^2}$

DIGITAL OUTPUT SIGNAL y(t)

FIG. 14

ANALOG INPUT x (nT)

y (nT) DIGITAL OUTPUT TO DECIMATION FILTER

EP 0 450 951 A2

34

## FIG. 15